**Europäisches Patentamt**

**European Patent Office**

**Office européen des brevets**

(19)

(11) Veröffentlichungsnummer : **0 428 880 B1**

(12)

# EUROPÄISCHE PATENTSCHRIFT

(45) Veröffentlichungstag der Patentschrift :
**01.12.93 Patentblatt 93/48**

(51) Int. Cl.$^5$ : **C03C 14/00, H01L 21/48, H01L 23/15, H05K 1/03, H01B 3/08**

(21) Anmeldenummer : **90120266.3**

(22) Anmeldetag : **23.10.90**

(54) **Keramische Stoffzusammensetzung und ihre Verwendung.**

(30) Priorität : **25.10.89 DE 3935471**

(43) Veröffentlichungstag der Anmeldung :
**29.05.91 Patentblatt 91/22**

(45) Bekanntmachung des Hinweises auf die
Patenterteilung :
**01.12.93 Patentblatt 93/48**

(84) Benannte Vertragsstaaten :
**BE DE DK ES FR GB GR IT LU NL**

(56) Entgegenhaltungen :
**EP-A- 0 204 261**
**GB-A- 2 108 103**
**US-A- 4 746 346**

(73) Patentinhaber : **HOECHST
AKTIENGESELLSCHAFT
D-65926 Frankfurt (DE)**

(72) Erfinder : **Foley, Paul
P.O. Box 350
Oldwick, NJ 08858 (US)**
Erfinder : **Buckpesch, Rainer
Frankfurter Strasse 1
W-6238 Hofheim am Taunus (DE)**

EP 0 428 880 B1

## Beschreibung

Die Erfindung betrifft eine keramische Stoffzusammensetzung, die bei niedrigen Temperaturen sinterbar ist, sowie daraus hergestellte Substrate und Multilayer-Gehäuse für die Mikroelektronik sowie ein Verfahren zu deren Herstellung.

Keramische Stoffzusammensetzungen werden bei der Herstellung elektrischer Schaltelemente und Vorrichtungen in großem Maße angewandt, beispielsweise bei der Herstellung von mehrschichtigen keramischen Strukturen, die im allgemeinen aus einer Anzahl von Schichten eines keramischen Isoliermaterials mit dazwischen angeordneten schichtförmigen Mustern aus Metall bestehen (sog. Multilayer-Keramiken).

Daneben sind auch einlagige keramische Plättchen (sog. Substrate) von Bedeutung. Die Plättchen sollten eine niedrige Dielektrizitätskonstante und einen niedrigen thermischen Ausdehnungskoeffizienten aufweisen, damit sie als Trägermaterial für Hochfrequenz-Schaltungen geeignet sind. Diese Parameter hängen im wesentlichen nur von der chemischen Zusammensetzung ab.

Aus der US-PS 4,528,275 ist bereits eine Mullit-Silikatglas-Zusammensetzung bekannt, die als Substrat-Material geeignet ist und deren Wärmeausdehnungskoeffizient etwa dem von Silicium entspricht. Im gleichen Dokument wird die Herstellung eines Substratmaterials beschrieben, das aus Mullit und Cordierit besteht, aber keine zusammenhängende Glasphase enthält.

Aus der US-PS 4,413,061 ist ein Verfahren zur Herstellung von Substraten bekannt, bei dem man spezielle Gläser unter Zusatz eines Keimbildners aufschmilzt und tempert. Materialien, die unter diesen Bedingungen nicht schmelzen, fehlen. Dabei wird ein Teil des Glases in $\alpha$-Cordierit umgewandelt und es enststehen Substrate aus gesinterter Glas-Keramik.

Aus der DE-OS 24 60 931 sind Stoffzusammensetzungen bekannt, die beim Sintern zu keramischen Körpern mit niedriger Dielektrizitätskonstante führen und die aus einem polykristallinen, keramischen feuerfesten Material und einem im Zwischengitterbereich angeordneten Glas bestehen. Zur Herstellung der sinterbaren Zusammensetzung wird ein feuerfester Stoff, beispielsweise Cordierit, und ein Glas mit niedriger Sintertemperatur, niedriger Dielektrizitätskonstante und geringer Wärmedehnung, z.B. Borsilikatglas, in fein verteilter Form gründlich gemischt und gesintert. Während der Sinterung schmilzt das Glas und füllt die zwischen den feuerfesten Teilchen liegenden Hohlräume im Zwischengitterbereich aus.

Der Erfindung liegt die Beobachtung zugrunde, daß die Herstellung keramischer Sinterkörper erleichtert wird, wenn als Ausgangsmaterial nicht Cordierit, sondern ein Gemisch aus $Al_2O_3$, feinteiligem Magnesiumoxid und grobteiligem Siliciumdioxid eingesetzt wird.

Die Erfindung betrifft daher eine keramische Stoffzusammensetzung, die bei niedrigen Temperaturen sinterbar ist und die zu 40 bis 90 Gew.-% aus einem feinverteilten, schwer schmelzbaren oxidischem Material und 10 bis 60 Gew.-% aus einem feinverteilten Glas mit einem Erweichungspunkt von 500 big 850°C, einem Wärmeausdehnungskoeffizienten (= WAK) von 2 bis 5 $\cdot$ 10$^{-6}$ K$^{-1}$ (gemessen im Intervall von 0 bis 400°C) und einer Dielektrizitätskonstante unter 5 (gemessen bei 10$^6$ Hz und 20°C) besteht. Diese Stoffzusammensetzung ist dadurch ausgezeichnet, daß das feinverteilte oxidische Material aus MgO, $Al_2O_3$ und $SiO_2$, mit einem Gewichtsverhältnis $Al_2O_3/MgO$ von 1,8-4 und einem Gewichtsanteil an $SiO_2$ von 42-65 Gew.-% oder einer äquivalenten Menge von entsprechenden Oxidvorläufern besteht, die beim Erhitzen zu diesen Oxiden zerfallen, und das MgO, bzw. der MgO-Vorläufer, eine mittlere Korngröße von 0,05 bis 3 $\mu$m ($d_{50}$-Wert) und das $SiO_2$, bzw. der $SiO_2$-Vorläufer, eine mittlere Korngröße von 2 bis 20 $\mu$m ($d_{50}$-Wert) aufweist und das feinverteilte Glas maximal 0,01 Gew% $K_2O$ + $Na_2O$ enthält und frei von Zinkoxid ist.

Der Anteil an $SiO_2$ beträgt vorzugsweise 43-60 Gew.-%, insbesondere 43-55 Gew.-%. Das Gewichtsverhältnis $Al_2O_3/MgO$ beträgt vorzugsweise 2-3, insbesondere 2,2-2,7, besonders bevorzugt 2,4-2,6.

Die mittlere Korngröße des beim Sintern eingesetzten Magnesiumoxid-Pulvers (oder des entsprechenden Vorläufers) liegt vorzugsweise im Bereich von 0,1 bis 3 $\mu$m ($d_{50}$-Wert). Die mittlere Korngröße des beim Sintern eingesetzten $SiO_2$-Pulvers liegt vorzugsweise bei 10 bis 20 $\mu$m ($d_{50}$-Wert).

Die Korngröße des eingesetzten Aluminiumoxid-Pulvers scheint keinen signifikanten Einfluß auf die Sintereigenschaften auszuüben. Die Korngröße kann beispielsweise im Bereich zwischen 0,5 und 25 $\mu$m liegen. Für die Herstellung einer flexiblen grünen Keramikfolie mit möglichst wenig organischen Hilfsstoffen sollte die spezifische Oberfläche der eingesetzten Pulver nicht zu hoch sein, da sonst der Bedarf an Bindemittel zu hoch wird. Bevorzugt sind spezifische Oberflächen der eingesetzten Pulver von 1 bis 20 m²/g, insbesondere 1 bis 10 m²/g.

Beim Erhitzen der erfindungsgemäßen Zusammensetzung reagieren die Oxide, bzw. Oxid-Vorläufer, unter Bildung von Cordierit. Je höher der Anteil an gebildetem Cordierit ist, umso günstiger sind Thermoschockbeständigkeit und elektronische Eigenschaften.

Ein Überschuß an freiem $SiO_2$ in der Glaskeramik verbessert $\varepsilon$ aber verschlechtert den WAK.

Ansätze mit feinverteilten MgO zeigen (unabhängig vom $SiO_2$) eine niedrigere Sintertemperatur $T_1$ , ein

niedriges Sinterende $T_2$ und eine kleinere Sinterbreite ($T_2$-$T_1$) als Ansätze mit grobem Magnesiumoxid. Eine Kombination von feinem Magnesiumoxid und grobem $SiO_2$ führt darüberhinaus zu einer beträchtlichen Erhöhung der Erweichungstemperatur $T_s$. Die Korngröße des Aluminiumoxids beeinflußt die Sinterparameter dagegen nicht. Es ist ein Vorteil der erfindungsgemäßen keramischen Zusammensetzung, daß das verfügbare Arbeitsintervall ($T_s$-$T_2$) groß ist. Ein Arbeitsintervall von mindestens 50 K läßt sich ohne weiteres erreichen.

Oxidvorläufer für Magnesiumoxid sind z.B. Magnesiumhydroxid und Magnesiumcarbonat. Oxidvorläufer für $Al_2O_3$ sind z.B. Bauxit (AlOOH) oder Al(OH)$_3$. Das Siliziumdioxid kann eingesetzt werden als Quarz, Cristobalit, amorpher Quarz oder Tridymit.

Wie bereits in US-PS 4413061 beschrieben, sind Glaskeramiken für bestimmte Anwendungszwecke reinem Aluminiumoxid überlegen, das für viele Zwecke eine zu hohe Dielektrizitätskonstante ($\varepsilon$ = 10) aufweist. Nach dem Sintern ergibt die erfindungsgemäße keramische Zusammensetzung einen keramischen Körper, der aus einem Skelett des keramischen feuerfesten Materials und einem die Zwischenkornbereiche ausfüllenden Glas besteht. Das eingesetzte, fein verteilte, polykristalline feuerfeste Material bestehend aus MgO, $Al_2O_3$ und $SiO_2$ wandelt sich in Cordierit um, der ebenfalls eine niedrige Dielektrizitätskonstante ($\varepsilon$ = 4,5-5,1) aufweist. Das beim Sintern gebildete feuerfeste Skelett gibt dem Material im wesentlichen die notwendigte Biegefestigkeit. Feuerfestes Material und Glas sind zusammen verantwortlich für die niedrige Dielektrizitätskonstante und die geringen elektrischen Verluste bei hohen Frequenzen. Der Glas-Bestandteil ist in der Hauptsache verantwortlich für die niedrige Sintertemperatur, die gute chemische Beständigkeit und den hohen elektrischen Isolationswiderstandes des beim Sintern entstehenden keramischen Formkörpers.

Aus der erfindungsgemäßen Zusammensetzung lassen sich durch Sintern dichte Glaskeramik-Formkörper gewinnen, die sich gut als Trägermaterial für elektronische Bauelemente eignen.

Die erfindungsgemäße Zusammensetzung gestattet es, Folien aus ungebrannter Keramik herzustellen, die gleichzeitig mit einer aufgebrachten Metallisierung sintern. Dies ist beispielsweise wichtig bei der Bildung von mehrschichtigen Strukturen, sog. Multi-Layer-Packages. In diesem Fall ist es notwendig, hoch schmelzende edle Metalle, wie z. B. Platin oder Palladium für die Metallisierung zu verwenden. Unedle Metallen, wie Wolfram oder Molybdän, erfordern die Einhaltung einer reduzierenden Atmosphäre beim Sintern. Nachteilig ist ferner die geringe elektrische Leitfähigkeit dieser Metalle.Die erfindungsgemäßen Zusammensetzungen lassen sich bei niedrigen Temperaturen sowohl in einer oxidierenden wie in einer reduzierenden Atmosphäre verdichten und gleichzeitig mit Metallisierungen verbinden, die hervorragende elektrische Leitfähigkeit aufweisen, wie z. B. Kupfer, Silber, Gold oder deren Legierungen mit Pt oder Pd, beispielsweise Ag-Cu, Ag-Pd, Au-Pd oder Au-Pt.

Da die neuen keramischen Stoffzusammensetzungen sich leicht auf eine hohe Dichte (geschlossenes Porenvolumen unter 5 %) sintern lassen, kann man aus ihnen Schichten erzeugen, die für Gase und Flüssigkeiten absolut undurchlässig sind und daher für hermetische Abdichtungen geeignet sind, insbesondere für Trennflächen zwischen keramischen Materialien und Metallen.

Das im Zwischenkornbereich befindliche Glas des keramischen Sinterkörpers hat gemäß der vorliegenden Erfindung zwei Funktionen. Zum einen dient es als Bindemittel für das feuerfeste Material und zum anderen wirkt es als Flußmittel beim Flüssigphasensintern und ermöglicht überhaupt das Verdichten der Zusammensetzung bei niedrigen Temperaturen. Wegen des niedrigen Erweichungspunktes von 500 bis 850°C der Glasphase sind Sintertemperaturen von 900 bis 1100°C, insbesondere 900 bis 1000°C, möglich. Nach dem Erkalten des beim Sintern erhaltenen Formkörpers ist das Glas für die Formhaltigkeit und Maßhaltigkeit der Körper verantwortlich. Ein Erweichen des Sinterkörpers bei Temperaturen unter 500°C ist von Nachteil, da sonst die Gefahr besteht, daß sich das Bauteil bei späteren Verarbeitungsprozessen verformt. Daher soll auch der Erweichungspunkt der Glasphase nicht unter 500°C liegen.

Mit steigendem Gewichtsanteil an Glas in der erfindungsgemäßen Zusammensetzung (innerhalb des Bereichs von 10 bis 60 Gew. -%) verringert sich die Sintertemperatur ($T_2$) und die Erweichungstemperatur $T_s$, letztere aber wesentlich stärker. Die Differenz beider Temperaturen wird daher geringer. Man wird daher den Glasanteil so hoch wählen, daß eine Sintertemperatur erreicht wird, die etwas niedriger liegt als die Sintertemperatur des Metalls der eingesetzten Metallpaste und andererseits die Erweichungstemperatur $T_s$ um mindestens 50 K, vorzugsweise um mindestens 100 K, höher liegt als die Sintertemperatur.

Vorzugsweise besitzt das eingesetzte Glas einen thermischen Ausdehnungskoeffizienten von von 2,5 bis 4,5 $\cdot$ $10^{-6}$ $K^{-1}$. Die Dielektrizitätskonstante des Glases ist vorzugsweise kleiner als 4,5. Bevorzugt sind Gläser, die eine gute chemische Beständigkeit aufweisen und auch bei reduzierenden Atmosphären keine Veränderungen zeigen. Für diesen speziellen Einsatzzweck sind Gläser mit einem Gehalt an ZnO, $SnO_2$, PbO oder Eisenoxiden von Nachteil.

Das im Zwischenkornbereich angeordnete Glas ermöglicht beim Sintern eine hohe Rohdichte, die mind. 93 % der theoretisch erreichbaren beträgt. Zur Herstellung eines Formkörpers, insbesondere eines Single-layer-Substrats oder eines Multi-layer-Gehäuses wird die erfindungsgemäße Zusammensetzung mit organi-

3

schen Hilfsstoffen vermischt, z.B. Dispergiermittel, Bindemittel, Weichmacher, Trennmittel und gegebenenfalls Entschäumer und Lösungsmittel. Aus dieser Mischung wird durch Gießen oder ein anderes Formgebungsverfahren eine dünne Schicht des ungebrannten Materials (Grünkörper) erzeugt. Auf der Oberfläche der so erzeugten Grünfolie wird ein geometrisches Muster einer leitfähigen oder beim Sintern leitfähig werdenden Zusammensetzung aufgebracht, beispielsweise durch Siebdruck. Als Metallisierungsmaterial wird ein Metall oder eine Legierung ausgewählt, deren Paste bei der Sintertemperatur eingebrannt werden kann. Dabei handelt es sich im allgemeinen um Pasten aus Gold, Gold/Pt und Ag/Pd. Es können auch Kupferpasten verwendet werden; jedoch muß in diesem Fall unter Sauerstoffausschluß eingebrannt werden.

Bei der Herstellung von Substraten durch Trockenpressen beträgt der Organik-Anteil ca. 0,5 bis 3 Gew.-%. Bei der Herstellung von biegsamen grünen Keramik-Folien liegt der Anteil an organischen Hilfsstoffen bei 5 bis 20 Gew.-%, der Anteil an erfindungsgemäßer keramischer Stoffzusammensetzung bei 80 bis 95 Gew.-%. Die Foliendicke liegt meist bei 0,1 bis 2, insbesondere 0,1 bis 1 mm.

Die so erzeugte keramische Grünfolie kann bei entsprechender Dicke direkt zu einem Single-Layer-Substrat mit einer Dicke von etwa 0,3 - 1,5 mm mit oder ohne Metallisierung gebrannt werden.

Zur Herstellung von Multi-Layer-Gehäusen aus Grünfolien, die aus keramischem Pulver und organischen Zusätzen, z.B. Binder, bestehen, werden aus den Folien eine Vielzahl von Karten ausgestanzt, diese gegebenenfalls mit Löchern versehen, die dann mit Metallpaste ausgefüllt und später eine leitfähige Verbindung durch die Karte hindurch ergeben, und dann mit einer Paste, die neben Binder und Lösemittel ein schwer schmelzbares Metall wie Silber, Kupfer, Gold oder Wolfram enthält, beschichtet, z.B. durch Siebdruck oder durch Lithographie, wobei eine geometrische Struktur ausgebildet wird. Mindestens zwei dieser mit Metallpaste bedruckten grünen Karten werden übereinandergestapelt, so daß eine Sandwich-Struktur entsteht, und zusammenlaminiert (d.h. eine kurze Zeit bei erhöhter Temperatur zusammengepreßt). Das erhaltene Laminat wird langsam aufgeheizt, um die organischen Bestandteile zu entfernen und dann weiter auf eine Temperatur von 900-1100°C, insbesondere 900-1000°C, aufgeheizt. Dabei sintert die keramische Zusammensetzung der Folie zu einer Glaskeramik und der Metallanteil der Paste zu einer elektrisch leitfähigen Leiterbahn.

Als Brennunterlage eignet sich z.B. eine Metallplatte, eine Platte aus Mullit oder Aluminiumoxid, deren Rauhigkeit der Oberfläche des gewünschten Formkörpers entsprechen sollte. Die Oberfläche der gebrannten Keramik kann hinsichtlich Rauhigkeit oder Krümmung nicht besser sein, als es die Beschaffenheit der Brennunterlage ermöglicht. Für den Brand in reduzierenden Atmosphären sind Brennunterlagen aus Molybdän- oder Wolfram-Blechen geeignet.

Gläser, die bei $10^6$ Hz und 20°C eine Dielektrizitätskonstante von maximal 5 aufweisen, sind dem Fachmann bekannt. Hauptsächlich werden Borsilikat oder Aluminium-Borsilikat-Gläser einschließlich binärer, ternärer oder quaternärer Gläser verwandt, z.B. aus den Systemen $B_2O_3$-$SiO_2$, $Al_2O_3$-$B_2O_3$-$SiO_2$ oder $Li_2O$-$Al_2O_3$-$B_2O_3$-$SiO_2$, (Lithium-Bor-Silikat-Glas). Verwendbar sind auch Borphosphat und Lithiumtetraborat-Gläser. Ein Lithium-Bor-Silikat-Glas mit Gehalten an $K_2O$ + $Na_2O$ wird in der DE-OS 24 60 931, Seite 22 angegeben.

In N.P. Bansal und R.H. Doremus, Handbook of Glas Properties, Academic Press, 1986 wird ein Natriumborsilikat-Glas (Table 14.38), ein Lithiumsilikat-Glas (Table 14.1) sowie mehrere technische Glassorten der Corning Glass Works angegeben (Corning No. 3320, 7040, 7070 und 7720 - Table 3.9). Weitere brauchbare Gläser sind aufgeführt in Encyclopedia of Glass, Ceramics and Cement, John Wiley, 1985, S. 481-486, Tabelle 3 und 4.

Es ist vorteilhaft, wenn das verwendete Glas nur wenig Alkaliionen, insbesondere Natrium- und Kalium-Ionen enthält. Bevorzugt ist ein Gehalt von maximal 0,01 Gew.-% Natriumoxid + Kaliumoxid. Vorzugsweise beträgt der Anteil des Glases 20 bis 40 Gew.-% (Rest: feuerfestes Material). Je höher der prozentuale Glasanteil der Zusammensetzung ist, desto niedriger liegt die Sintertemperatur und die Dielektrizitätskonstante.

Diese bei niedrigen Sintertemperaturen verdichtbaren Materialien ermöglichen, besonders in der Mehrschichttechnologie, folgende Vorteile:

- Niedrigere Sintertemperaturen, d.h. Kosteneinsparungen.
- Einfache Sinterprofile, sowohl oxidierende als auch reduzierende Atmosphären (Wasserstoff) sind möglich.
- Einsatz von einfachen Durchlauföfen ist möglich.
- Der Einsatz von korrosionsbeständigen, elektrisch gut leitenden Metallpasten ist möglich.
- Die niedrigere Dielektrizitätskonstante des keramischen Trägermaterials gemäß der vorliegenden Erfindung führt zu einer deutlich kleineren Signalverzögerung.
- Ein an den thermischen Ausdehnungskoeffizient des Siliziums besser angepaßten Wert, was deutlich geringere Spannungen zwischen Substratmaterial und dem Siliziumchip bei Temperatur-Wechselbeanspruchungen zur Folge hat. Unter Verwendung dieses Substratmaterials kann somit dem Trend nach dem Einsatz von größeren Siliziumchips Rechnung getragen werden.
- Die der Erfindung zugrundeliegenden Werkstoffe weisen eine deutlich höhere Thermoschockbeständigkeit auf, als das heute zum überwiegenden Teil eingesetzte Aluminiumoxid.

- Die geringere Härte des Materials macht eine Nachbearbeitung, wie z.B. Läppen, Polieren, Anbringen von Durchkontaktierungen z.B. mit Hilfe eines Lasers leichter möglich.

Zur Herstellung von keramischen Sinterkörpern mit hohen Anforderungen an die Maßtoleranzen muß die exakte Schwindung der Grünfolie beim Brand bekannt sein und exakt eingehalten werden, da eine nachträgliche Bearbeitung in der Regel hohe Kosten erfordert.

Die zur Formgebung der Grünfolien notwendigen organischen Hilfsstoffe werden bei Temperaturen bis 500°C ausgetrieben.

Die Sintertemperatur von unter 950°C läßt sich nach einer Aufheizzeit von wenigen Minuten bis zu maximal einer Stunde erreichen. Zur vollständigen Verdichtung des keramischen Körpers ist eine Haltezeit auf der maximalen Temperatur von mindestens einer Stunde notwendig. Wenn man einen Durchlaufofen mit Förderband verwendet, so muß die Durchlaufgeschwindigkeit des Bandes im Ofen so eingestellt sein, daß die organischen Hilfsstoffe vollständig entfernt werden, bevor der eigentliche Sinterprozeß einsetzt. Ferner muß darauf geachtet werden, daß die maximal mögliche Aufheizgeschwindigkeit (das ist die Geschwindigkeit, bei der im Endprodukt eben noch keine schädlichen Risse oder Blasen auftreten) nicht überschritten und die notwendige Haltezeit nicht unterschritten wird.

Das nach dem Sintern anfallende keramische Single-Layer-Substrat (mit und ohne Metallisierung) bzw. das Multi-Layer-Gehäuse mit Metallisierung kann mit den sonst üblichen Fertigungsverfahren weiter zu IC-Gehäusen verarbeitet werden. Beispielsweise können die außen liegenden Leiterbahnen noch verchromt und vergoldet werden.

Die Erfindung wird durch die nachfolgenden Beispiele erläutert.

**Beispiel 1** (Vergleichsbeispiel)

Magnesiumoxid (Teilchengrößen-Verteilung bezogen auf Gewichtsanteile: $d_{10}$ = 1,5 µm, $d_{50}$ = 18,5 µm, $d_{90}$ = 38,8 µm), Aluminiumoxid (Teilchengrößen-Verteilung: $d_{10}$ = 1,6 µm, $d_{50}$ = 3,7 µm und $d_{90}$ = 6,4 µm) und Quarz (Teilchengrößen-Verteilung: $d_{10}$ = 1,9 µm, $d_{50}$ = 18,2 µm und $d_{90}$ = 50 µm) wurden im Gewichtsverhältnis 15,4 Gew.-% MgO, 45,8 Gew.-% $SiO_2$ und 38,8 Gew.-% $Al_2O_3$ vereinigt und gründlich gemischt. Zu der Pulvermischung wurde pulverförmiges Lithium-Borsilikat-Glas (Teilchengrößen-Verteilung: $d_{10}$ = 1,8 µm, $d_{50}$ = 8,1 µm und $d_{90}$ = 32,2 µm, Glas-Transformationspunkt 491°C) im Gewichtsverhältnis Oxidgemisch/Glas von 70/30 gegeben. Diese Mischung wurde in Gegenwart von Isopropanol während 4 Stunden in einer Attritormühle in Gegenwart von Aluminiumoxid-Mahlsteinen gemahlen. Das Isopropanol wurde im Vakuum entfernt und das Pulver bei 200°C getrocknet. Danach zeigte die Teilchengrößen-Verteilung für die Vier-Komponenten-Pulvermischung folgende Werte: $d_{10}$ = 0,51 µm, $d_{50}$ = 2,1 µm und $d_{90}$ = 4,8 µm.

Das getrocknete Pulver wurde isostatisch zu einem zylinderförmigen Probekörper gepreßt und bei 1075°C gesintert. Dabei betrug die Aufheizgeschwindigkeit (wie in den anderen Beispielen) 5°C/min., ohne Anhalten bei Erreichen der Sintertemperatur. Die erhaltene Keramik zeigte einen dilatometrisch gemessenen Erweichungspunkt von 1154°C und einen Verarbeitungsbereich von 79 K (= Differenz zwischen Erweichungspunkt und Sintertemperatur). Die Eigenschaften der erhaltenen Glaskeramik (mit Ausnahme der Sinterparameter) sind in Tabelle 1 aufgeführt. Sie treffen in erster Näherung auch für die Keramiken der anderen Beispiele zu. Das Röntgenbeugungsspektrum zeigte, daß Cordierit, Mullit und Sapphirin als keramische Phasen vorhanden waren.

## Tabelle 1

| Eigenschaften | Glaskeramik |
|---|---|
| Wasserlöslichkeit | gering |
| Wärmeleitfähigkeit (W/m K) | ca. 2,3 |
| Biegebruchfestigkeit (MPa) | ca. 189 |
| E-Modul (GPa) | ca. 101 |
| Reduktionsbeständigkeit | Gut |
| Thermoschockbeständigkeit | >400°C |
| Dielektrizitätskonstante (1 MHz) | ca. 5,0 |
| Tan δ (1 MHz) | ca. 2,9 $\times 10^{-3}$ |
| Widerstand (ohm cm) | $>10^{+9}$ |
| Kristallphasen | Cordierit, Mullit, Sapphirin |

**Beispiel 2**

Beispiel 1 wurde wiederholt, jedoch lag in der Sintermischung gröberes Quarz vor. Magnesiumoxid, Aluminiumoxid und Glaspulver wurden wie in Beispiel 1 gemahlen. Die Teilchengrößen-Verteilung der erhaltenen Pulvermischung war: $d_{10} = 0,51$ µm, $d_{50} = 2,1$ µm und $d_{90} = 4,8$ µm. Zu dieser Mischung wurde dann Quarz (Teilchengrößen-Verteilung: $d_{10} = 1,9$ µm, $d_{50} = 18,2$ µm und $d_{90} = 50$ µm) gegeben und das Pulver während 15 Minuten gemischt.

Der analog erhaltene Probezylinder sinterte bei 1036°C und ergab einen dichten keramischen Körper. Dieser zeigte einen Erweichungspunkt von 1317°C, was einem Verarbeitungsbereich von 281 K entspricht.

**Beispiel 3**

Beispiel 2 wurde wiederholt, jedoch wurde beim Aufheizen bei Erreichen einer Temperatur von 1000°C eine Pause von 2 Stunden eingelegt. Es wurde ein dichtgesinterter keramischer Körper erhalten, mit den gleichen Eigenschaften wie der Keramikkörper von Beispiel 2.

**Beispiel 4** (Vergleichsbeispiel)

Beispiel 1 wurde wiederholt, jedoch war in der Sintermischung sowohl die Teilchengröße von Magnesiumoxid wie von Quarz größer. Aluminiumoxid und Lithium-Borsilikat-Glas wurden wie in Beispiel 1 in Isopropanol gemahlen. Es entstand ein Pulver mit folgender Teilchengrößen-Verteilung:
$d_{10} = 0,51$ µm, $d_{50} = 2,1$ µm und $d_{90} = 4,8$ µm.
Zu dieser Mischung wurde Quarz (Teilchengrößen-Verteilung:
$d_{10} = 1,9$ µm, $d_{50} = 18,2$ µm und $d_{90} = 50$ µm) und Magnesiumoxid von Beispiel 1 gegeben. Das Gewichtsverhältnis der vier Komponenten war gegenüber Beispiel 1 unverändert. Das erhaltene Gemisch wurde während 15 Minuten homogen gemischt und dann das Lösungsmittel entfernt. Ein durch isostatisches Pressen erzeugter Formkörper sinterte bei 1172°C zu einem dichten keramischen Körper mit einem Erweichungspunkt von 1229°C. Dies entspricht einem Verarbeitungsbereich von 57 K.

**Beispiel 5**

Beispiel 2 wurde wiederholt, jedoch war die Korngröße des eingesetzten Aluminiumoxids größer. Magnesiumoxid und Lithium-Borsilikat-Glas wurden in Isopropanol gemahlen. Das erhaltene Pulvergemisch hatte folgende Teilchengrößen-Verteilung: $d_{10} = 0,51$ µm, $d_{50} = 2,1$ µm und $d_{90} = 4,8$ µm. Zu dieser Mischung wurde Quarz (Teilchengrößen-Verteilung wie in Beispiel 2) und Aluminiumoxid ($d_{10}$ = 4 μm, $d_{50}$ = 25 μm und $d_{90}$ = 50 μm) gegeben. Die Gewichtsanteile der vier Komponenten waren gegenüber Beispiel 1 unverändert. Die erhaltene Suspension wurde während 15 Minuten gemischt und dann das Lösungsmittel entfernt. Ein durch isostatisches Pressen erhaltener Formkörper sinterte zu einem dichten keramischen Körper bei 1050°C. Es wurde ein Erweichungspunkt von 1332°C gemessen, was einem Verarbeitungsbereich von 282 K entspricht.

**Beispiel 6** (Vergleichsbeispiel)

Beispiel 4 wurde wiederholt, jedoch war die Korngröße des Aluminiumoxids größer. Nur das Lithium-Borsilikat-Glas von Beispiel 1 wurde 3,75 Stunden in Isopropanol gemahlen. Die Teilchengrößen-Verteilung betrug:
$d_{10}$ = 0,51 μm, $d_{50}$ = 2,1 μm und $d_{90}$ = 4,8 μm für das erhaltene Pulver. Zu dieser Mischung wurden Quarz und Magnesiumoxid (wie in Beispiel 1) und Aluminiumoxid (wie in Beispiel 4) gegeben. Die Suspension wurde während 15 Minuten bis zur Homogenität gemischt. Die Gewichtsanteile der 4 Komponenten waren wie in Beispiel 1. Nach Entfernen des Lösungsmittels durch Abdampfen im Vakuum und Trocknen wurde das Pulver isostatisch zu einem Formkörper verformt und bei 1174°C zu einem dichten keramischen Formkörper gesintert. Dieser Körper zeigte einen Erweichungspunkt von 1227°C, was einem Verarbeitungsbereich von 53 K entspricht.

**Beispiel 7**

Mischungen aus MgO, $Al_2O_3$, $SiO_2$ und Glas in den Gewichtsverhältnissen von Beispiel 1 wurden verpreßt und gesintert. Der Sintervorgang wurde dilatometrisch verfolgt.
Die mittlere Korngröße des Glases betrug in allen Fällen 2 μm. Die mittlere Korngröße der Oxide geht aus Tabelle 2 hervor:

### Tabelle 2

| Versuch | MgO | $Al_2O_3$ | $SiO_2$ |
|---------|------|-----------|---------|
| 1 | 2 μm | 3,7 μm | 2 μm |
| 2 | 18,5 | " | " |
| 3 | 2 | 25 μm | " |
| 4 | 18,5 | " | " |
| 5 | 2 | 3,7 | 18,2 μm |
| 6 | 18,5 | " | " |
| 7 | 2 | 25 | " |
| 8 | 18,5 | " | " |

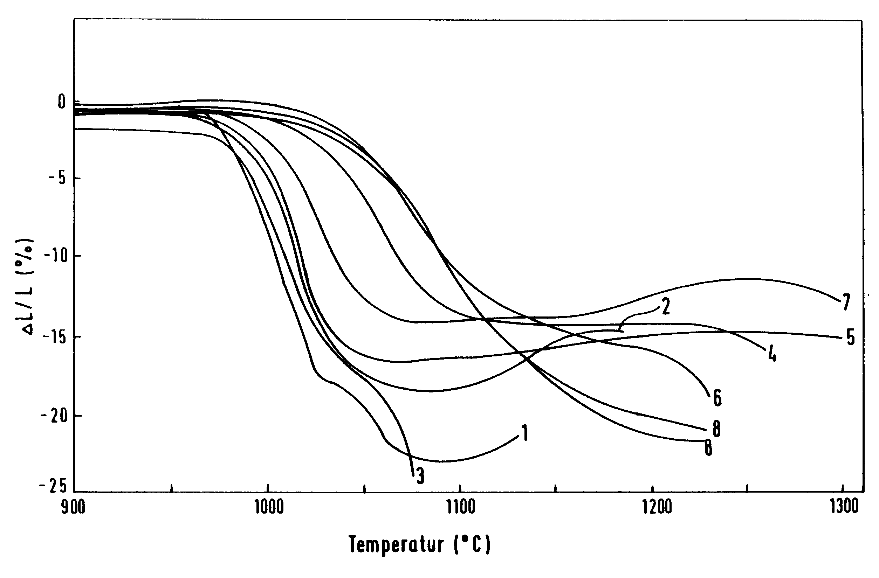

Die erhaltene Dilatometerkurven sind in der Figur dargestellt. Die Ordinate zeigt die Schwindung Δ L/L in %, die Abszisse die Temperatur in °C. Versuche 5 und 7 sind erfindungsgemäß.

**Patentansprüche**

**Patentansprüche für folgende Vertragsstaaten : BE, DE, DK, FR, GB, GR, IT, LU, NL**

1. Keramische Stoffzusammensetzung zur Herstellung eines Cordierit enthaltenden glaskeramischen Materials, die bei niedrigen Temperaturen sinterbar ist, bestehend zu
   a) 40 bis 90 Gew.-% aus einem feinverteilten, schwer schmelzbaren oxidischen Material und
   b) 10 bis 60 Gew.-% aus einem feinverteilten Glas mit einem Erweichungspunkt von 500 bis 850°C, einem Wärmeausdehnungskoeffizienten (= WAK) von 2 bis $5 \cdot 10^{-6}$ $K^{-1}$ (gemessen im Intervall von 0 bis 400°C) und einer Dielektrizitätskonstante unter 5 (gemessen bei $10^6$ Hz und 20°C), dadurch gekennzeichnet, daß das feinverteilte oxidische Material aus MgO, $Al_2O_3$ und $SiO_2$ mit einem Gewichtsverhältnis $Al_2O_3/MgO$ von 1,8-4 und einem Gewichtsanteil an $SiO_2$ von 42-65 Gew.-% oder einer äquivalenten Menge von entsprechenden Oxidvorläufern besteht, die beim Erhitzen zu diesen Oxiden zerfallen, das MgO, bzw. der MgO-Vorläufer eine mittlere Korngröße von 0,05 bis 3 μm und das $SiO_2$, bzw. der $SiO_2$-Vorläufer, eine mittlere Korngröße von 2 bis 20 μm aufweist, das feinverteilte Glas maximal 0,01 Gew.-% $K_2O$ + $Na_2O$ enthält und frei ist von Zinkoxid.

2. Zusammensetzung gemäß Anspruch 1, dadurch gekennzeichnet, daß das eingesetzte feinverteilte Glas ein Borsilikat-Glas ist.

3. Zusammensetzung gemäß Anspruch 1, dadurch gekennzeichnet, daß man als feinverteiltes Glas ein Lithium-Bor-Silikat-Glas einsetzt.

4. Zusammensetzung gemäß Anspruch 1, dadurch gekennzeichnet, daß man ein Glas einsetzt, das frei ist von Bleioxid.

5. Grüne keramische Folie mit einer Schichtdicke von 0,1 bis 2 mm, enthaltend 5 bis 20 Gew.-% organische Komponenten und 80 bis 95 Gew.-% eines feinverteilten, sinterfähigen keramischen Vorproduktes, dadurch gekennzeichnet, daß als keramisches Vorprodukt die keramische Stoffzusammensetzung gemäß Anspruch 1 vorhanden ist.

6. Verfahren zur Herstellung eines Cordierit enthaltenden glaskeramischen Substrates, wobei man die Zusammensetzung gemäß Anspruch 1 mit organischen Hilfsstoffen vermischt, die Mischung zu einem dünnen schichtförmigen Formkörper verformt, den grünen Formkörper langsam aufheizt bis die organischen Hilfsstoffe entfernt sind und dann bei einer Temperatur von 900 bis 1100°C, insbesondere 900 bis 1000°C, sintert.

7. Verfahren zur Herstellung eines Multi-Layer-Gehäuses aus Cordierithaltiger Glaskeramik, wobei man mindestens 2 keramische Grünfolien gemäß Anspruch 5 herstellt, man auf der Oberfläche von mindestens zwei Grünfolien unter Verwendung einer Metallisierungspaste, die Metallpulver, Binder und ein Lösemittel enthält, eine schichtförmige geometrische Struktur erzeugt, man die einzelnen Grünfolien übereinanderstapelt, so daß eine Sandwichstruktur entsteht, man die Grünfolien zusammenlaminiert, man das Laminat aufheizt, um die organischen Bestandteile zu entfernen und danach weiter auf eine Temperatur von 900 - 1100°C, aufheizt, wobei die Zusammensetzung von Anspruch 1 zu einer Glaskeramik und die Metallteilchen der Paste zu einer elektrisch leitfähigen Leiterbahn zusammensintern.

8. Verfahren nach Anspruch 7, dadurch gekennzeichnet, daß man eine Metallisierungspaste verwendet, deren Metallanteil bei 800 - 1000°C sintert.

**Patentansprüche für folgenden Vertragsstaat : ES**

1. Grüne keramische Folie zur Herstellung eines Cordierit enthaltenden glaskeramischen Gegenstander mit einer Schichtdicke von 0,1 bis 2 mm, enthaltend 5 bis 20 Gew.-% organische Komponenten und 80 bis 95 Gew.-% eines feinverteilten, sinterfähigen keramischen Vorproduktes, bestehend zu
   a) 40 bis 90 Gew.-% aus einem feinverteilten, schwer schmelzbaren oxidischen Material und
   b) 10 bis 60 Gew.-% aus einem feinverteilten Glas mit einem Erweichungspunkt von 500 bis 850°C, einem Wärmeausdehnungskoeffizienten (= WAK) von 2 bis $5 \cdot 10^{-6}$ $K^{-1}$ (gemessen im Intervall von 0 bis 400°C) und einer Dielektrizitätskonstante unter 5 (gemessen bei $10^6$ Hz und 20°C), dadurch gekennzeichnet, daß das feinverteilte oxidische Material aus MgO, $Al_2O_3$ und $SiO_2$ mit einem Gewichtsverhältnis $Al_2O_3/MgO$ von 1,8-4 und einem Gewichtsanteil an $SiO_2$ von 42-65 Gew.-% oder einer äquivalenten Menge von entsprechenden Oxidvorläufern besteht, die beim Erhitzen zu diesen Oxiden zerfallen, das MgO, bzw. der MgO-Vorläufer eine mittlere Korngröße von 0,05 bis 3 μm und das $SiO_2$, bzw. der $SiO_2$-Vorläufer, eine mittlere Korngröße von 2 bis 20 μm aufweist, das feinverteilte Glas maximal 0,01 Gew.-% $K_2O$ + $Na_2O$ enthält und frei ist von Zinkoxid.

2. Grüne keramische Folie gemäß Anspruch 1, dadurch gekennzeichnet, daß das eingesetzte feinverteilte Glas ein Borsilikat-Glas ist.

**3.** Grüne keramische Folie gemäß Anspruch 1, dadurch gekennzeichnet, daß man als feinverteiltes Glas ein Lithium-Bor-Silikat-Glas einsetzt.

**4.** Grüne keramische Folie gemäß Anspruch 1, dadurch gekennzeichnet, daß man ein Glas einsetzt, das frei ist von Bleioxid.

**5.** Verfahren zur Herstellung eines Cordierit enthaltenden glaskeramischen Substrates, wobei man eine keramische Stoffzusammensetzung hergestellt, die bei niedrigen Temperaturen sinterbar ist und zu

a) 40 bis 90 Gew.-% aus einem feinverteilten, schwer schmelzbarem oxidischen Material und

b) 10 bis 60 Gew.-% aus einem feinverteilten Glas mit einem Erweichungspunkt von 500 bis 850°C, einem Wärmeausdehnungskoeffizienten (= WAK) von 2 bis $5.10^{-6}$ $K^{-1}$ (gemessen im Intervall von 0 bis 400°C) und einer Dielektrizitätskonstante unter 5 (gemessen bei $10^6$ Hz und 20°C),

besteht, dadurch gekennzeichnet, daß das feinverteilte oxidische Material aus MgO, $Al_2O_3$ und $SiO_2$ mit einem Gewichtsverhältnis $Al_2O_3/MgO$ von 1,8-4 und einem Gewichtsanteil an $SiO_2$ von 42-65 Gew.-% oder einer äquivalenten Menge von entsprechenden Oxidvorläufern besteht, die beim Erhitzen zu diesen Oxiden zerfallen, das MgO, bzw. der MgO-Vorläufer eine mittlere Korngröße von 0,05 bis 3 $\mu$m und das $SiO_2$, bzw. der $SiO_2$-Vorläufer, eine mittlere Korngröße von 2 bis 20 $\mu$m aufweist, das feinverteilte Glas maximal 0,01 Gew.-% $K_2O$ + $Na_2O$ enthält und frei ist von Zinkoxid, man die keramische Stoffzusammensetzung mit organischen Hilfsstoffen vermischt, die Mischung zu einem dünnen schichtförmigen Formkörper verformt, den grünen Formkörper langsam aufheizt bis die organischen Hilfsstoffe entfernt sind und dann bei einer Temperatur von 900 bis 1100°C, insbesondere 900 bis 1000°C, sintert.

**6.** Verfahren zur Herstellung eines Multi-Layer-Gehäuses aus cordierithaltiger Glaskeramik, wobei man mindestens 2 keramische Grünfolien gemäß Anspruch 1 herstellt, man auf der Oberfläche von mindestens zwei Grünfolien unter Verwendung einer Metallisierungspaste, die Metallpulver, Binder und ein Lösemittel enthält, ein schichtförmiges geometrisches Muster erzeugt, man die einzelnen Grünfolien übereinanderstapelt, so daß eine Sandwichstruktur entsteht, man die Grünfolien zusammenlaminiert, man das Laminat langsam aufheizt, um die organischen Bestandteile zu entfernen und danach weiter auf eine Temperatur von 900 - 1100°C, aufheizt, wobei die keramische Zusammensetzung zu einer Glaskeramik und die Metallteilchen der Paste zu einer elektrisch leitfähigen Leiterbahn zusammensintern.

**7.** Verfahren nach Anspruch 6, dadurch gekennzeichnet, daß man eine Metallisierungspaste verwendet, deren Metallanteil bei 800 - 1000°C sintert.

## Claims

### Claims for the following Contracting States : BE, DE, DK, FR, GB, GR, IT, LU, NL

**1.** A ceramic composition of matter for the production of a glass-ceramic material containing cordierite, which composition is sinterable at low temperatures and is composed of

a) 40 to 90% by weight of a finely disperse, high-melting oxidic material and

b) 10 to 60% by weight of a finely disperse glass having a softening point of 500 to 850°C, a coefficient of thermal expansion (= CTE) of 2 to $5 \times 10^{-6}$ $K^{-1}$ (measured in the interval from 0 to 400°C) and a dielectric constant of less than 5 (measured at $10^6$ Hz and 20°C),

wherein the finely disperse oxidic material is composed of MgO, $Al_2O_3$ and $SiO_2$ in an $Al_2O_3/MgO$ weight ratio of 1.8-4 with an $SiO_2$ weight fraction of 42-65% by weight or an equivalent quantity of corresponding oxide precursors which, on heating, decompose to give these oxides, and the MgO or the MgO precursor has a mean grain size of 0.05 to 3 $\mu$m and the $SiO_2$ or the $SiO_2$ precursor has a mean grain size of 2 to 20 $\mu$m, and the finely disperse glass contains not more than 0.01% by weight of $K_2O$ + $Na_2O$ and is free of zinc oxide.

**2.** A composition as claimed in claim 1, wherein the finely disperse glass used is a borosilicate glass.

**3.** A composition as claimed in claim 1, wherein the finely disperse glass used is a lithium borosilicate glass.

**4.** A composition as claimed in claim 1, wherein a glass is used which is free of lead oxide.

**5.** A green ceramic sheet of 0.1 to 2 mm thickness, containing 5 to 20% by weight of organic components and 80 to 95% by weight of a finely disperse, sinterable ceramic intermediate, wherein a ceramic composition of matter as claimed in claim 1 is present as the ceramic intermediate.

6. A process for producing a glass-ceramic substrate containing cordierite, which comprises mixing the composition as claimed in claim 1 with organic auxiliaries, shaping the mixture to give a thin stratiform molding, slowly heating the green molding until the organic auxiliaries have been removed, and then sintering at a temperature from 900 to 1100°C, especially 900 to 1000°C.

7. A process for producing a multi-layer housing from glass ceramics containing cordierite, which comprises producing at least 2 ceramic green sheets as claimed in claim 5, generating a stratiform geometrical structure on the surface of at least two green sheets with the use of a metallization paste which contains metal powder, binder and a solvent, stacking up the individual green sheets to form a sandwich structure, laminating the green sheets together, heating the laminate in order to remove the organic constituents and then further heating to a temperature of 900-1100°C, when the composition as claimed in claim 1 sinters together to give a glass ceramic and the metal particles of the paste sinter together to give an electrically conductive track.

8. The process as claimed in claim 7, wherein a metallization paste is used, the metal fraction of which sinters at 800-1000°C.

## Claims for the following Contracting State : ES

1. A green ceramic sheet for the production of a glass-ceramic article containing cordierite, of 0.1 to 2 mm thickness, containing 5 to 20% by weight of organic components and 80 to 95% by weight of a finely disperse, sinterable ceramic intermediate, composed of
   a) 40 to 90% by weight of a finely disperse, high-melting oxidic material and
   b) 10 to 60% by weight of a finely disperse glass having a softening point of 500 to 850°C, a coefficient of thermal expansion (= CTE) of 2 to $5 \times 10^{-6}$ $K^{-1}$ (measured in the interval from 0 to 400°C) and a dielectric constant of less than 5 (measured at $10^6$ Hz and 20°C),
   wherein the finely disperse oxidic material is composed of $MgO$, $Al_2O_3$ and $SiO_2$ in an $Al_2O_3/MgO$ weight ratio of 1.8-4 with an $SiO_2$ weight fraction of 42-65% by weight or an equivalent quantity of corresponding oxide precursors which, on heating, decompose to give these oxides, and the MgO or the MgO precursor has a mean grain size of 0.05 to 3 $\mu$m and the $SiO_2$ or the $SiO_2$ precursor has a mean grain size of 2 to 20 $\mu$m, and the finely disperse glass contains not more than 0.01% by weight of $K_2O + Na_2O$ and is free of zinc oxide.

2. A green ceramic sheet as claimed in claim 1, wherein the finely disperse glass used is a borosilicate glass.

3. A green ceramic sheet as claimed in claim 1, wherein the finely disperse glass used is a lithium borosilicate glass.

4. A green ceramic sheet as claimed in claim 1, wherein a glass is used which is free of lead oxide.

5. A process for producing a glass-ceramic substrate containing cordierite, in which a ceramic composition of matter is prepared which is sinterable at low temperatures and is composed of
   a) 40 to 90% by weight of a finely disperse, high-melting oxidic material and
   b) 10 to 60% by weight of a finely disperse glass having a softening point of 500 to 850°C, a coefficient of thermal expansion (= CTE) of 2 to $5 \times 10^{-6}$ $K^{-1}$ (measured in the interval from 0 to 400°C) and a dielectric constant of less than 5 (measured at $10^6$ Hz and 20°C),
   wherein the finely disperse oxidic material is composed of $MgO$, $Al_2O_3$ and $SiO_2$ in an $Al_2O_3/MgO$ weight ratio of 1.8-4 with an $SiO_2$ weight fraction of 42-65% by weight or an equivalent quantity of corresponding oxide precursors which, on heating, decompose to give these oxides, and the MgO or the MgO precursor has a mean grain size of 0.05 to 3 $\mu$m and the $SiO_2$ or the $SiO_2$ precursor has a mean grain size of 2 to 20 $\mu$m, and the finely disperse glass contains not more than 0.01% by weight of $K_2O + Na_2O$ and is free of zinc oxide, the ceramic composition is mixed with organic auxiliaries, the mixture is shaped to give a thin stratiform molding, the green molding is slowly heated until the organic auxiliaries have been removed, and then sintered at a temperature from 900 to 1100°C, especially 900 to 1000 °C.

6. A process for producing a multi-layer housing from glass ceramics containing cordierite, which comprises producing at least 2 ceramic green sheets as claimed in claim 1, generating a stratiform geometrical pattern on the surface of at least two green sheets with the use of a metallization paste which contains metal powder, binder and a solvent, stacking up the individual green sheets to form a sandwich structure, laminating the green sheets together, slowly heating the laminate in order to remove the organic constituents and then further heating to a temperature of 900-1100°C, when the ceramic composition sinters together to give a glass ceramic and the metal particles of the paste sinter together to give an electrically conductive track.

7. The process as claimed in claim 6, wherein a metallization paste is used, the metal fraction of which sinters at 800-1000°C.

**Revendications**

**Revendications pour les Etats contractants suivants : BE, DE, DK, FR, GB, GR, IT, LU, NL**

1. Composition céramique pour la production d'un objet vitrocéramique contenant de la cordiérite, qui est frittable à de basses températures et consiste en :

   a) 40 à 90 % en poids d'une matière oxydée finement répartie et difficilement fusible,

   b) 10 à 60% en poids d'un verre finement réparti ayant un point de ramollissement de 500 à 850°C, un coefficient de dilatation thermique (CDT) de 2 à $5.10^{-6}K^{-1}$ (mesuré dans l'intervalle de 0 à 400°C) et une constante diélectrique inférieure à 5 (mesurée à $10^{-6}$ Hz et 20°C), composition caractérisée en ce que la matière oxydée finement répartie consiste en MgO, $Al_2O_3$ et $SiO_2$ selon un rapport pondéral $Al_2O_3/MgO$ de 1,8-4 et une proportion pondérale de $SiO_2$ de 42 à 65 % en poids ou une quantité équivalente de précurseurs correspondants des oxydes qui se décomposent par chauffage en donnant ces oxydes; le MgO ou le précurseur de MgO ayant une grosseur moyenne des grains de 0,05 à 3 $\mu$m et le $SiO_2$ ou le précurseur de $SiO_2$ ayant une grosseur moyenne des grains de 2 à 20 $\mu$m; le verre finement réparti contenant au maximum 0,01 % en poids de ($K_2O+Na_2O$) et étant dépourvu d'oxyde de zinc.

2. Composition selon la revendication 1, caractérisée en ce que le verre finement réparti que l'on utilise est un verre de borosilicate.

3. Composition selon la revendication 1, caractérisée en ce qu'on utilise comme verre finement réparti un verre de borosilicate de lithium.

4. Composition selon la revendication 1, caractérisé en ce qu'on utilise un verre qui est dépourvu d'oxyde de plomb.

5. Feuille céramique verte ayant une épaisseur de couche de 0,1 à 2 mm, contenant 5 à 20 % en poids de constituants organiques et 80 à 95 % en poids d'un précurseur céramique de produit frittable, finement réparti, feuille caractérisée en ce qu'elle comporte comme précurseur de produit céramique la composition céramique selon la revendication 1.

6. Procédé pour produire un substrat vitrocéramique contenant de la cordiérite, selon lequel on mélange la composition selon la revendication 1 avec des adjuvants organiques, on met le mélange sous forme d'un objet moulé ayant la forme d'une couche mince, on chauffe lentement l'objet moulé vert jusqu'à élimination des adjuvants organiques et l'on fritte ensuite à une température de 900 à 1100°C, notamment de 900 à 1000°C.

7. Procédé pour produire un boîtier multicouches en vitrocéramique contenant de la cordiérite, selon lequel on produit au moins deux feuilles vertes céramique selon la revendication 5, on produit sur la surface d'au moins deux feuilles vertes, en utilisant une pâte de métallisation contenant de la poudre de métal, du liant et un solvant, une structure géométrique en forme de couche, on empile les unes sur les autres les diverses feuilles vertes de façon qu'il en résulte une structure de type "sandwich", on stratifie ensemble les feuilles vertes, on chauffe le stratifié pour éliminer les constituants organiques et l'on chauffe ensuite encore jusqu'à une température de 900 à 1100°C, de sorte que la composition selon la revendication 1 se fritte en donnant une vitrocéramique et les particules de métal de la pâte se frittent ensemble en donnant une piste conductrice de l'électricité.

**8.** Procédé selon la revendication 7, caractérisé en ce qu'on utilise une pâte de métallisation dont la partie métallique se fritte à 800-1000°C.

## Revendications pour l'Etat contractant suivant : ES

**1.** Feuille céramique verte pour produire un objet vitrocéramique contenant de la cordiérite, cette feuille ayant une épaisseur de couche de 0,1 à 2 mm, contenant 5 à 20 % en poids de constituants organiques et 80 à 95 % en poids d'un précurseur de produit céramique frittable, finement réparti, consistant en :
a) 40 à 90 % en poids d'une matière oxydée difficilement fusible et finement répartie, et
b) 10 à 60 % en poids d'un verre finement réparti ayant un point de ramollissement de 500 à 850°C, un coefficient de dilatation thermique (CDT)de 2 à $5.10^{-6}$ $K^{-1}$ (coefficient mesuré dans l'intervalle de 0 à 400°C) et une constante diélectrique inférieure à 5 (mesurée à $10^{-6}$ Hz et 20°C), feuille caractérisée en ce que la matière oxydée finement répartie consiste en MgO, $Al_2O_3$ et $SiO_2$ ayant un rapport pondéral $Al_2O_3/MgO$ de 1,8 à 4 et une proportion pondérale de $SiO_2$ de 42 à 65 % en poids ou une quantité équivalente de précurseurs des oxydes correspondants, qui se décomposent par chauffage en donnant ces oxydes; le MgO ou le précurseur de MgO ayant une grosseur moyenne des grains de 0,05 à 3 $\mu$m et le $SiO_2$ ou le précurseur de $SiO_2$ ayant une grosseur moyenne des grains de 2 à 20 $\mu$m; le verre finement réparti contenant au maximum 0,01 % en poids de ($K_2O$ + $Na_2O$) et étant dépourvu d'oxyde de zinc.

**2.** Feuille céramique verte selon la revendication 1, caractérisée en ce que le verre finement réparti que l'on y utilise est un verre de borosilicate.

**3.** Feuille céramique verte selon la revendication 1, caractérisée en ce qu'on utilise comme verre finement réparti un verre de borosilicate de lithium.

**4.** Feuille céramique verte selon la revendication 1, caractérisée en ce qu'on utilise un verre qui est dépourvu d'oxyde de plomb.

**5.** Procédé pour produire un substrat vitrocéramique contenant de la cordiérite, selon lequel on produit une composition céramique qui est frittable à basse température et qui consiste :
a) pour 40 à 90 % en poids en une matière oxydée finement répartie et difficilement fusible, et
b) pour 10 à 60 % en un verre finement réparti présentant un point de ramollissement de 500 à 850°C, un coefficient de dilatation thermique (CDT)de 2 à $5.10^{-6}K^{-1}$ (mesuré dans l'intervalle de 0 à 400°C) et une constante diélectrique inférieure à 5 (mesurée à $10^{-6}$Hz et 20°C), procédé caractérisé en ce que la matière oxydée finement répartie consiste en MgO, $Al_2O_3$ et $SiO_2$ présentant un rapport pondéral $Al_2O_3/MgO$ de 1,8-4 et une proportion pondérale de $SiO_2$ de 42 à 65 % en poids ou une quantité équivalente des précurseurs des oxydes correspondants, qui, par chauffage, se décomposent en donnant ces oxydes; en ce que le MgO ou le précurseur de MgO présente une grosseur moyenne des grains de 0,05 à 3 $\mu$m et le $SiO_2$ ou le précurseur de $SiO_2$ présente une grosseur moyenne des grains de 2 à 20 $\mu$m; le verre finement réparti contient au maximum 0,01 % en poids de ($K_2O$ + $Na_2O$) et est dépourvu d'oxyde de zinc; en ce que l'on mélange la composition céramique avec des adjuvants organiques, on met le mélange sous forme d'un objet moulé en forme de couches minces, on soumet l'objet moulé vert à un lent chauffage jusqu'à disparition des adjuvants organiques, puis on le fritte à une température de 900 à 1100°C, notamment de 900 à 1000°C.

**6.** Procédé pour produire un boîtier multicouches en vitrocéramique contenant de la cordiérite, selon lequel on produit au moins deux feuilles vertes céramiques selon la revendication 1, on produit sur la surface d'au moins deux feuilles vertes, en utilisant une pâte de métallisation contenant de la poudre de métal, du liant et un solvant, un dessin ou modèle géométrique en forme de couche, on empile les unes sur les autres les diverses feuilles vertes de sorte qu'il en résulte une structure en "sandwich", on stratifie ensemble le feuilles vertes; on chauffe lentement le stratifié pour en éliminer les constituants organiques et on le chauffe ensuite à une température de 900 à 1100°C, la composition céramique se frittant en donnant de la vitrocéramique et les particules de métal de la pâte se frittent ensemble en donnant une piste conductrice de l'électricité.

**7.** Procédé selon la revendication 6, caractérisé en ce qu'on utilise une pâte de métallisation dont la partie métallique se fritte à 800-1000°C.

EP 0 428 880 B1